# EUROPÄISCHE PATENTSCHRIFT

(11) **EP 1 922 586 B1**
(45) Veröffentlichungstag und Bekanntmachung des Hinweises auf die Patenterteilung: **11.05.2016**
(21) Anmeldenummer: 06776955.4
(22) Anmeldetag: 18.08.2006
(51) Int. Cl.: G03F 7/20

(54) **AUSTAUSCHVORRICHTUNG FÜR EIN OPTISCHES ELEMENT**
REPLACEMENT DEVICE FOR AN OPTICAL ELEMENT
DISPOSITIF DE REMPLACEMENT POUR UN ELEMENT OPTIQUE

(30) Priorität: 23.08.2005 US 710680 P
(43) Veröffentlichungstag der Anmeldung: 21.05.2008
(73) Patentinhaber: Carl Zeiss SMT GmbH, 73447 Oberkochen (DE)
(72) Erfinder: GELLRICH, Bernhard, 73434 Aalen (DE); WEBER, Ulrich, 89075 Ulm (DE)
(74) Vertreter: Lorenz, Markus
(86) Internationale Anmeldenummer: PCT/EP2006/008160
(87) Internationale Veröffentlichungsnummer: WO 2007/022922

(56) Entgegenhaltungen:
- EP-A2- 1 406 107
- WO-A-2005/050323
- US-A1- 2005 134 972

## Beschreibung

Die Erfindung betrifft eine Austauschvorrichtung für wenigstens ein in einer lithographischen Projektionsbelichtungsanlage zumindest mittelbar gelagertes austauschbares optisches Element. Die Erfindung betrifft weiterhin ein Lithographieobjektiv und ein Beleuchtungssystem. Darüber hinaus betrifft die Erfindung ein Verfahren zur Positionierung eines austauschbaren optischen Elements innerhalb einer derartigen lithographischen Projektionsbelichtungsanlage und ein Verfahren zum Austauschen eines austauschbaren optischen Elements innerhalb einer lithographischen Projektionsbelichtungsanlage mittels einer Austauschvorrichtung.

Es sind Lithographieobjektive bekannt, bei denen das letzte optische Element, also dasjenige, das dem zu belichtenden Wafer am nächsten liegt, austauschbar ist.

Bezüglich des die Erfindung betreffenden Standes der Technik wird auf die US 2002/0167740 A1, die US 6, 654, 101 B2 und die US 5, 726, 740 verwiesen.

Die WO 2005/050323 A1 betrifft eine optische Baugruppe mit mehreren optischen Elementen, wobei wenigstens ein optisches Element mit einer dynamisch von der optischen Baugruppe entkoppelten Struktur verbunden ist, wodurch es von den restlichen optischen Elementen und der optischen Baugruppe im Wesentlichen dynamisch entkoppelt ist.

Wenn sich die optischen Elemente, wie beispielsweise Linsen oder Spiegel, innerhalb eines Lithographieobjektivs als Anlagenteil einer Projektionsbelichtungsanlage im Laufe der Zeit verändern, z.B. durch Kontaminationen oder Materialveränderungen, und sich die Leistung des Objektivs derart verschlechtert, dass die angestrebte Lebensdauer desselben nicht erreicht werden kann, so sollte es, insbesondere im Einsatzbereich mit möglichst geringem Aufwand möglich sein, ein entsprechend ausgewähltes optisches Element innerhalb des Objektivs zu entfernen und dafür ein neues, entsprechend bearbeitetes optisches Element einzusetzen, welches insbesondere auch die Abbildungsfehler der anderen optischen Elemente ausgleichen kann.

Solange es sich bei den auszutauschenden optischen Elementen um Planparallelplatten oder um optische Elemente mit geringer Brechkraft handelt, sind bei einem Tausch neben hohen Anforderungen hinsichtlich Deformationen im Wesentlichen enge Toleranzen für Kippeinstellung und Z-Position, d.h. Position entlang der optischen Achse einzuhalten. Die laterale Verschiebung senkrecht zur optischen Achse spielt hierbei eine eher untergeordnete Rolle. Mit zunehmender Brechkraft bzw. zunehmender Sensitivität gegenüber Dezentrierungen gewinnt aber auch die laterale Verschiebung (Zentrierung zur optischen Achse) an Bedeutung.

Problematisch sind hauptsächlich Fertigungstoleranzen beim Austausch. Typischerweise kommen zum Ausgleich derartiger Fertigungstoleranzen auf Maß geschliffene Abstimmscheiben bzw. Abstandscheiben bzw. Spacer zum Einsatz. Dies erfordert jedoch eine aufwendige Logistik und Dokumentation, da die genauen Einbauzustände jedes potentiell auszutauschenden optischen Elements erfasst und archiviert werden müssen. Der Satz Abstandscheiben (z.B. sechs Abstandscheiben für eine Einstellung in sechs Freiheitsgraden) des neu einzubauenden optischen Elements muss abhängig von den vorhandenen Fertigungstoleranzen gefertigt und dem auszutauschenden optischen Element fest zugeordnet werden.

Werden aufgrund der höheren Anforderungen für höher auflösende optische Systeme die Toleranzen für die Position nach einem derartigen Austausch so gering, dass ein Ausgleich der mechanischen Fertigungstoleranzen durch Abstandscheiben nicht mehr möglich ist, so muss eine andere Lösung für die Einhaltung der Positionstoleranzen nach einem Tausch gefunden werden. Diese Grenze ist beispielsweise dann erreicht, wenn Abstandscheiben mit einer Genauigkeit von < 1 *µ*m bis weit in den Sub-*µ*m-Bereich hinein auf Maß geschliffen werden sollten.

Wenn die auszutauschenden optischen Elemente z.B. Linsen mit entsprechender Brechkraft sind, können die Positionstoleranzen für die Kippeinstellung bzw. die Verkippung (Rotation um rx, ry, rz) sowie für die axiale und die laterale Verschiebung (x, y, z) im Bereich weniger 10 nm liegen. In diesem Fall sind die konventionellen Konzepte mit Abstandsscheiben nicht ausreichend, da derartige Genauigkeiten nicht mehr erreicht werden können.

Es ist daher Aufgabe der vorliegenden Erfindung, eine Austauschvorrichtung für ein in einer lithographischen Projektionsbelichtungsanlage zumindest mittelbar gelagertes optisches Element zu schaffen, die einen derartigen Austausch mit hohen Genauigkeiten ermöglicht.

Gemäß der Erfindung ist hierzu eine Austauschvorrichtung für wenigstens ein in einer lithographischen Projektionsbelichtungsanlage zumindest mittelbar gelagertes in einer Fassung angeordnetes austauschbares optisches Element vorgesehen, mit wenigstens einer Aufnahme für das austauschbare optische Element, welche durch wenigstens eine Öffnung in einem Gehäuse eines Anlagenteils der lithographischen Projektionsbelichtungsanlage in dasselbe einbringbar ist, wobei das austauschbare optische Element in dem Anlagenteil auf einer separaten Haltestruktur gehalten ist, wobei das austauschbare optische Element zur Fixierung auf der separaten Haltestruktur mittels der Fassung in eine entsprechend hinreichend steif ausgeführte Klemmeinrichtung eingebracht ist, deren Wirkkräfte im Wesentlichen nicht auf die separate Haltestruktur wirken bzw. wodurch die separate Haltestruktur von den Klemmkräften der Klemmeinrichtung wenigstens annähernd entkoppelt ist. Dadurch ist das Positionierungssystem von dem Fixierungssystem des optischen Elements in vorteilhafter Weise entkoppelt.

Diese Austauschvorrichtung ist in der Lage, das optische Element aus dem Anlagenteil zu entnehmen und ein anderes, speziell auf die Veränderungen innerhalb des Anlagenteils abgestimmtes optisches Element wieder in den Anlagenteil einzufahren bzw. zuzuführen. Es ist lediglich wenigstens eine Öffnung in dem Gehäuse des Anlagenteils erforderlich, welche so bemessen ist, dass die Aufnahme in das Gehäuse einfahren kann. Hierbei ist die Aufnahme in der Lage, das optische Element sehr genau innerhalb des Anlagenteils zu positionieren. Das austauschbare optische Element ist in dem Anlagenteil auf einer separaten Haltestruktur gehalten. Zur Fixierung auf der separaten Haltestruktur ist das austauschbare optische Element in eine Fixierungseinrichtung eingebracht. In vorteilhafter Weise wirken die Wirkkräfte der Fixierungseinrichtung nicht auf die separate Haltestruktur. Dadurch werden parasitäre Einflüsse auf die angrenzenden Komponenten minimiert. Der Kraftschluss wird lokal und nicht über die separate Haltestruktur geführt, sodass diese auch als Manipulatoreinrichtung zur Feinpositionierung eingesetzt werden kann.

Vorteilhaft ist, wenn der Anlagenteil ein Lithographieobjektiv und/oder ein Beleuchtungssystem oder Teile davon umfasst.

Hierdurch lässt sich etwa die Abbildungsleistung des Lithographieobjektivs erheblich verbessern, ohne dass in die Struktur des Lithographieobjektivs eingegriffen wird.

Erfindungsgemäß kann ferner vorgesehen sein, dass die wenigstens eine Aufnahme mittels einer Antriebseinrichtung und einer Führungseinrichtung motorisch einfahrbar ist.

Dadurch kann auch ein wenigstens teilautomatisierter Austausch erfolgen, um beispielsweise während des Betriebs des Lithographieobjektivs eine doppelte Belichtung eines Bereiches eines Substrats mit zwei unterschiedlichen Reticles durchführen zu können.

Das optische Element ist in vorteilhafter Weise in einer Fassung bzw. Wechselfassung angeordnet. Um Deformationen auf das optische Element zu vermeiden kann die Fassung im Bereich der Fixierungseinrichtung von Momenten der separaten Haltestruktur und/oder der Fixierungseinrichtung entkoppelt sein.

Vorteilhaft ist, wenn das austauschbare optische Element Referenzflächen zur Erfassung der Position und Orientierung desselben aufweist. Dadurch kann in vorteilhafter Weise sowohl beim Austauschvorgang als auch bei einer endgültigen Feinpositionierung des austauschbaren optischen Elements in dem Anlagenteil bzw. dem Lithographieobjektiv anhand der Referenzflächen eine genaue Position und Orientierung des austauschbaren optischen Elements bestimmt werden.

Zur groben Vorpositionierung des austauschbaren optischen Elements innerhalb des Anlagenteils auf der separaten Haltestruktur können Abstandsscheiben bzw. Abstimmscheiben bzw. Spacer vorgesehnen sein. Darüber sind auch einstellbare Anlageflächen denkbar.

In einer besonders vorteilhaften konstruktiven Ausgestaltung der Erfindung kann ferner vorgesehen sein, dass die separate Haltestruktur eine Manipulatoreinrichtung mit wenigstens einem Aktuator zur Einstellung des austauschbaren optischen Elements in wenigstens einem, insbesondere in sechs Freiheitsgraden aufweist.

Durch diese Maßnahmen kann das in die Fixierungseinrichtung bzw. Klemmeinrichtung eingebrachte, austauschbare optische Element in mehreren, insbesondere in sechs Freiheitsgraden einjustiert werden. Ein erstes Sensorsystem kann dazu zur Ermittlung der relativen Position und Orientierung des austauschbaren Elements zu dem Anlagenteil auf der separaten Haltestruktur vorgesehen sein. Die Feinpositionierung insbesondere im Bereich weniger 10 Nanometer des austauschbaren optischen Elements erfolgt hiernach mit den Daten des ersten Sensorsystems durch die Manipulatoreinrichtung und wird von einem ersten Steuerungssystem mittels eines geschlossenen Regelkreises geregelt.

Vorteilhaft ist es, wenn das austauschbare optische Element oder die Fassung in der das austauschbare optische Element angeordnet ist, innerhalb des Anlagenteils statisch bestimmt gelagert ist.

Erfindungsgemäß kann ferner vorgesehen sein, dass eine separate Zuführeinrichtung mit einer ersten Aufnahme für ein zuzuführendes austauschbares optisches Element, welche durch wenigstens eine erste seitliche Öffnung in dem Gehäuse des Anlagenteils in dasselbe einfahrbar ist, vorgesehen ist und dass eine separate Entnahmeeinrichtung mit einer zweiten Aufnahme für das zu entnehmende austauschbare optische Element, welche durch wenigstens eine zweite seitliche Öffnung in dem Gehäuse des Anlagenteils in dasselbe einfahrbar ist, vorgesehen ist.

Dadurch kann synchron und teilautomatisiert das zu entfernende austauschbare Element durch die Entnahmeeinrichtung entnommen und das zuzuführende austauschbare optische Element durch die Zuführeinrichtung zugeführt werden.

Vorteilhaft ist es, wenn wenigstens die Zuführeinrichtung oder die Entnahmeeinrichtung einen Speicher zur Ablage der zuzuführenden oder entnommenen austauschbaren optischen Elemente aufweisen.

Ein Lithographieobjektiv mit mehreren optischen Elementen und mit wenigstens einer erfindungsgemäßen Austauschvorrichtung ist in Anspruch 20 angegeben.

Des weiteren wird ein Beleuchtungssystem für die Mikrolithographie mit einer erfindungsgemäßen Austauschvorrichtung in Anspruch 21 vorgeschlagen.

In Anspruch 23 ist ein Verfahren zur Positionierung eines austauschbaren optischen Elements innerhalb eines Lithographieobjektivs mittels einer erfindungsgemäßen Austauschvorrichtung beschrieben.

Des weiteren ist ein Verfahren zum austauschen eines austauschbaren optischen Elements innerhalb eines Lithographieobjektivs mittels einer erfindungsgemäßen Austauschvorrichtung in Anspruch 24 angegeben.

Weitere vorteilhafte Ausgestaltungen und Weiterbildungen ergeben sich aus den restlichen Unteransprüchen. Nachstehend sind verschiedene Ausführungsbeispiele der Erfindung anhand der Zeichnung prinzipmäßig dargestellt.

Es zeigt:
- Figur 1: eine Prinzipdarstellung einer Projektionsbelichtungsanlage für die Mikrolithographie, welche zur Belichtung von Strukturen auf mit photosensitiven Materialien beschichtete Wafer verwendbar ist;
- Figur 2: eine Schnittansicht eines Lithographieobjektivs mit mehreren optischen Elementen und einer erfindungsgemäßen Austauschvorrichtung;
- Figur 3: eine Ausschnittsvergrößerung des Ausschnitts Z aus Figur 2; und
- Figur 4: eine Schnittansicht eines Lithographieobjektivs mit mehreren optischen Elementen und einer Austauschvorrichtung in einer weiteren Ausführungsform.

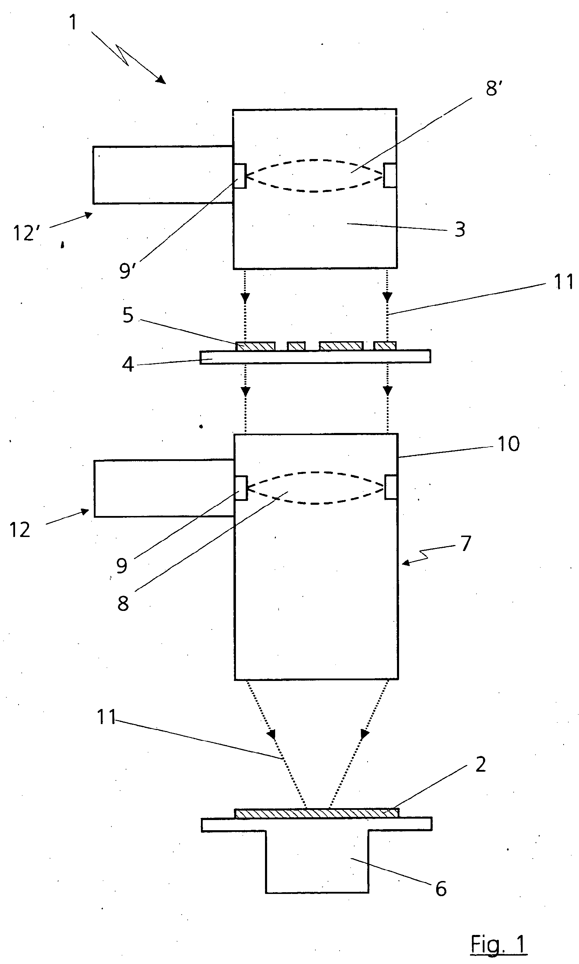

In Figur 1 ist eine Projektionsbelichtungsanlage 1 für die Mikrolithographie dargestellt. Diese dient zur Belichtung von Strukturen auf mit photosensitiven Materialien beschichtetes Substrat, welches im allgemeinen überwiegend aus Silizium besteht und als Wafer 2 bezeichnet wird, zur Herstellung von Halbleiterbauelementen, wie z.B. Computerchips.

Die Projektionsbelichtungsanlage 1 besteht dabei im wesentlichen aus einem Beleuchtungssystem 3, einer Einrichtung 4 zur Aufnahme und exakten Positionierung einer mit einer gitterartigen Struktur versehenen Maske, einem sogenannten Reticle 5, durch welches die späteren Strukturen auf dem Wafer 2 bestimmt werden, einer Einrichtung 6 zur Halterung, Bewegung und exakten Positionierung eben dieses Wafers 2 und einer Abbildungseinrichtung, nämlich einem Lithographieobjektiv bzw. Projektionsobjektiv 7 mit mehreren optischen Elementen, wie z.B. Linsen 8, die über Fassungen 9 und/oder in Fig. 1 nicht dargestellte Manipulatoren in einem Gehäuse 10 des Lithographieobjektivs 7 gelagert sind.

Das grundsätzliche Funktionsprinzip sieht dabei vor, dass die in das Reticle 5 eingebrachten Strukturen auf den Wafer 2 verkleinert abgebildet werden.

Nach einer erfolgten Belichtung wird der Wafer 2 entsprechend weiterbewegt, sodass auf demselben Wafer 2 eine Vielzahl von einzelnen Feldern, jeweils mit der durch das Reticle 5 vorgegebenen Struktur, belichtet werden.

Das Beleuchtungssystem 3 stellt einen für die Abbildung des Reticles 5 auf dem Wafer 2 benötigten Projektionsstrahl 11, beispielsweise Licht oder eine ähnliche elektromagnetische Strahlung, bereit. Als Quelle für diese Strahlung kann ein Laser oder dergleichen Verwendung finden. Die Strahlung wird in dem Beleuchtungssystem 3 über mehrere optische Elemente wie z.B. Linsen 8', die über Fassungen 9' in dem Beleuchtungssystem 3 gelagert sind, so geformt, dass der Projektionsstrahl 11 beim Auftreffen auf das Reticle 5 die gewünschten Eigenschaften hinsichtlich Durchmesser, Polarisation, Kohärenz und dergleichen aufweist.

Über den Projektionsstrahl 11 wird ein Bild der eingebrachten Strukturen des Reticles 5 erzeugt und von dem Lithographieobjektiv 7 entsprechend verkleinert auf den Wafer 2 übertragen, wie bereits vorstehend erläutert wurde. Das Lithographieobjektiv 7 weist eine Vielzahl von einzelnen refraktiven, diffraktiven und/oder reflektiven optischen Elementen, wie z.B. Linsen 8, Spiegeln, Prismen, Planparallelplatten und dergleichen auf, wobei in Fig. 1 lediglich die Linse 8 dargestellt ist.

Wenn sich die optischen Elemente, wie beispielsweise die Linsen 8 innerhalb des Lithographieobjektivs 7 im Laufe der Zeit verändern, z.B. durch Kontaminationen oder Materialveränderungen, und sich die Leistung des Lithographieobjektivs 7 derart verschlechtert, dass die angestrebte Lebensdauer desselben nicht erreicht werden kann, sollten diese austauschbar sein, um insbesondere auch die Abbildungsfehler der anderen in Fig. 1 nicht dargestellten optischen Elemente ausgleichen zu können. Des weiteren kann ein Austausch auch während des Betriebs erforderlich sein, um beispielsweise eine doppelte Belichtung eines Bereichs auf dem Wafer 2 mit zwei unterschiedlichen Reticles 5 durchführen zu können oder wenn unterschiedliche Polarisationen verwendet werden sollen. Ein derartiger Austausch muss natürlich hochgenau, wenigstens teilautomatisiert und sehr schnell durchführbar sein. Ebenso kann ein Austausch der Linse 8' auch bei dem Beleuchtungssystem 3 wünschenswert sein.

Falls es sich bei den auszutauschenden optischen Elementen, wie vorliegend um Linsen 8, 8' mit entsprechender Brechkraft handelt, können die Positionstoleranzen für die Kippeinstellung bzw. die Verkippung (Rotation um rx, ry, rz) sowie für die axiale und die laterale Verschiebung (z, x, y) im Bereich weniger 10 nm liegen. Derartige Genauigkeiten können mit Abstandsscheiben nicht mehr erreicht werden.

In Fig. 1 sind die optischen Elemente 8, 8' über stark vereinfacht dargestellte erfindungsgemäße Austauschvorrichtungen 12, 12' mit einer derart hohen Genauigkeit austauschbar ausgeführt.

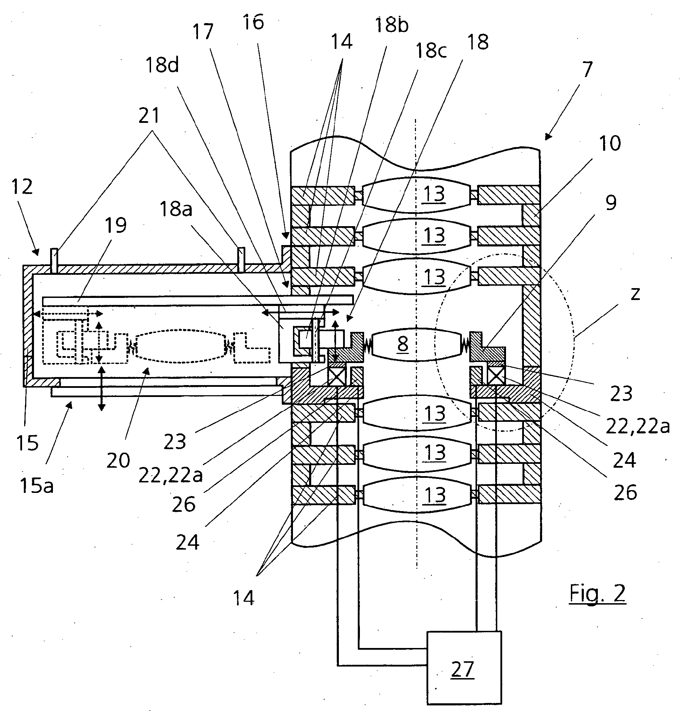

In Fig. 2 ist das Lithographieöbjektiv 7 mit mehreren in dem Gehäuse 10 angeordneten optischen Elementen 13, welche in Fassungen 14 angeordnet sind, dargestellt. Das austauschbare optische Element 8 ist in der Fassung 9 deförmationsentkoppelt angeordnet. Die Anordnung der optischen Elemente 13 innerhalb des Lithographieobjektivs 7 ist hierbei als rein beispielhaft anzusehen. Das Lithographieobjektiv 7 kann für jede Art der Lithographie geeignet sein. Bei dem Lithographieobjektiv 7 ist es wie nachfolgend beschrieben möglich, das optische Element 8 auszutauschen, welches direkt bzw. über die Fassung z.B. vorzugsweise statisch bestimmt in dem Lithographieobjektiv 7 gelagert ist.

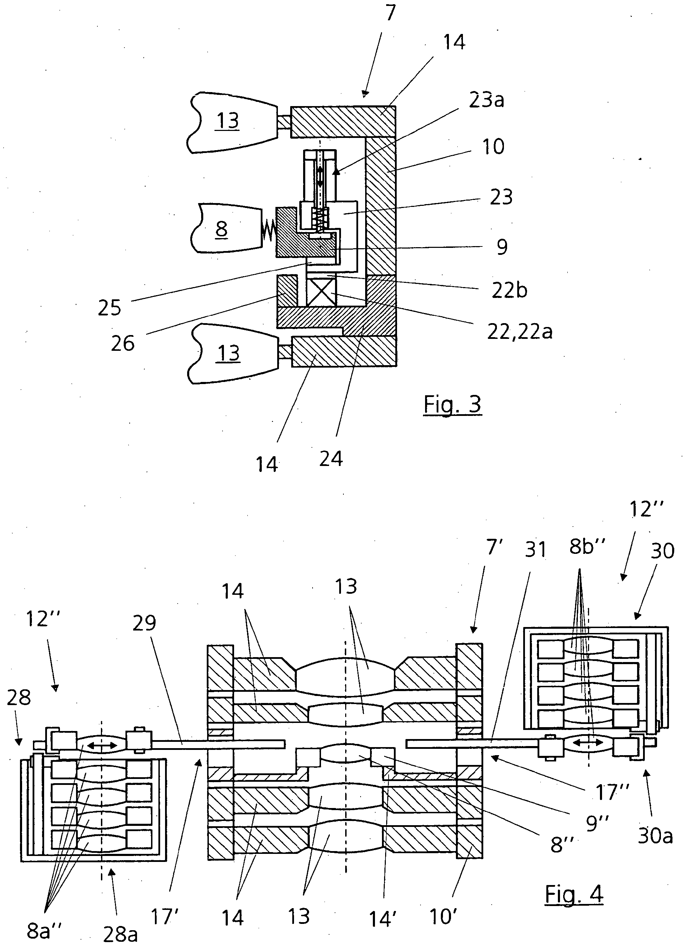

Wie weiter aus Figur 2 ersichtlich, ist zum Austausch des optischen Elements 8 in seiner Fassung 9 die Austauschvorrichtung 12 vorgesehen, welche ein Gehäuse 15 mit einem gasdichten Deckel 15a aufweist, welches über eine gasdichte Kopplung 16 mit dem Gehäuse 10 des Lithographieobjektivs 7 verbunden ist. Die Austauschvorrichtung 12 ist mit ausreichender Steifigkeit am Gehäuse 10 montiert bzw. verbleibt dort. Das Gehäuse 10 des Lithographieobjektivs 7 weist eine seitliche Öffnung 17 auf. Wie weiter aus Figur 2 ersichtlich, weist die Austauschvorrichtung 12 eine Aufnahme 18 für das optische Element 8 in seiner Fassung 9 auf. Die Aufnahme 18 ist durch die seitliche Öffnung 17 des Gehäuses 10 des Lithographieobjektivs 7 mittels einer nicht dargestellten Antriebseinrichtung und einer Führungseinrichtung 19 motorisch einfahrbar. Dazu sind eine Abhebeeinrichtung 18a, eine Einrichtung 18b zur Fixierung der Fassung 9 des optischen Elements 8 an der Abhebeeinrichtung 18a, eine Einrichtung 18c zur Führung der Abhebebewegung und eine Einrichtung 18d zur Bewegung der Abhebeeinrichtung vorgesehen, welche in der Führungseinrichtung 19 geführt ist. Die Position des optischen Elements 8 in der Austauschvorrichtung 12, d.h. außerhalb des Lithographieobjektivs 7 ist gestrichelt mit dem Bezugszeichen 20 angedeutet. Eine Ankopplung des Gehäuses 15 der Austauschvorrichtung 12 über kontrollierte Strömungsbedingungen um Kontamination des Lithographieobjektivs 7 zu vermeiden ist ebenfalls denkbar, d.h. der Druck im Inneren des Gehäuses 10 muss dabei größer sein als außerhalb des Gehäuses 10, damit eine gerichtete Strömung von innen nach außen entsteht. Die Austauschvorrichtung 12 kann mit einem hochreinen inerten Gas bzw. Gasgemisch durch Einlass- und Auslassöffnungen 21 gespült werden. Das austauschbare optische Element 8 in seiner Fassung 9 ist in dem Lithographieobjektiv 7 auf einer separaten Haltestruktur 22 gehalten. Die separate Haltestruktur weist eine Manipulatoreinrichtung 22a mit mehreren nicht dargestellten Aktuatoren zur Einstellung des austauschbaren optischen Elements 8 in z.B. vorzugsweise sechs Freiheitsgraden auf. In weiteren Ausführungsbeispielen können auch eine geringere Anzahl von Freiheitsgraden einstellbar sein. Die Fassung 9 des austauschbaren optischen Elements 8 ist zur Fixierung der separaten Haltestruktur 22 in eine als Klemmeinrichtung 23 ausgebildete Fixierungseinrichtung eingebracht. Die Klemmeinrichtung 23 ist in Figur 2 nur stark vereinfacht dargestellt, eine nähere Darstellung ist aus Figur 3 ersichtlich. Die separate Haltestruktur 22 weist z.B. zur isöstatischen Lagerung drei Auflagen mit Interfaces 22b (siehe Figur 3, beispielsweise nicht näher dargestellte V-Nuten, Kegel oder dergleichen), von denen in den Figuren nur jeweils zwei vereinfacht ersichtlich sind, auf. Die separate Haltestruktur 22 ist auf einer steifen Grundfassung 24, welche mit dem Gehäuse 10 des Lithographieobjektivs 7 verbunden ist, gehalten. Die separate Haltestruktur 22 ist relativ zu dem Lithographieobjektiv eindeutig bestimmt.

In einer Ausführung der Klemmvorrichtung nach Fig. 3 hat die in dem Lithographieobjektiv 7 verbleibende Klemmeinrichtung 23 ein Federelement 23a, welches die Fassung 9 des optischen Elements 8 fixiert. Wie weiter aus Figur 3 ersichtlich, wirken die Klemm- bzw. die durch die Fixierung bedingten Wirkkräfte der entsprechend hinreichend steif ausgeführten Klemmeinrichtung 23 lokal bzw. im Wesentlichen nicht auf die separate Haltestruktur 22 bzw. ist die separate Haltestruktur 22 von den durch die Fixierung bedingten Wirkkräften der Klemmeinrichtung 23 wenigstens annähernd entkoppelt. Die Klemmkräfte können manuell oder automatisch eingestellt werden. Zur groben Vorpositionierung des austauschbaren optischen Elements 8 bzw. der Fassung 9 sind z.B. Abstandsscheiben 25 vorgesehen. Des weiteren wären hier auch einstellbare Anlageflächen denkbar (nicht dargestellt). Die Klemmeinrichtung 23 wäre in der Ausführungsform nach Figur 3 vorzugsweise mit drei Modulen in 120°-Abständen um das optische Element 8 realisierbar. Dazu sind die einzelnen Module derart ausgebildet, dass das optische Element während des Austauschvorgangs an den Modulen vorbeiführbar ist. Die Feinpositionierung des optischen Elements 8 in der Fassung erfolgt durch die Manipulatoreinrichtung 22a. Dabei ist ein erstes Sensorsystem 26 zur Ermittlung der relativen Position und Orientierung des austauschbaren optischen Elements 8 zu der Grundfassung 24 oder zu anderen benachbarten optischen Elementen 13 bzw. zu einem Referenzpunkt oder Referenzpunkten vorgesehen. Zur Erfassung der Position und Orientierung weist das austauschbare optische Element 8 nicht dargestellte Referenzflächen auf. Die Feinpositionierung des austauschbaren optischen Elements 8 erfolgt mit den Daten des ersten Sensorsystems 26 durch die Manipulatoreinrichtung 22a von einem ersten Steuerungssystem 27.

Ein nicht dargestelltes im Bereich der Aufnahme 18 angeordnetes zweites Sensorsystem ermittelt die Position und die Orientierung des austauschbaren optischen Elements 8 während des Austauschvorgangs, wobei ein ebenfalls nicht dargestelltes zweites Steuerungssystem vorgesehen ist, welches die Führung und den Antrieb der Aufnahme 18 basierend auf der von dem zweiten Sensorsystem überwachten Position und Orientierung des austauschbaren optischen Elements 8 kontrolliert. Das austauschbare optische Element 8 bzw. die Fassung 9 sind innerhalb des Lithographieobjektiv 7 vorzugsweise statisch bestimmt gelagert.

Ein Verfahren zur Positionierung des austauschbaren optischen Elements 8 innerhalb des Lithographieobjektivs 7 mittels der Austauschvorrichtung 12 läuft dabei wie folgt ab:
- in einem ersten Schritt wird das austauschbare optische Element 8 auf die separate Haltestruktur 22, welche die Manipulatoreinrichtung 22a aufweist, abgelegt, wonach
- in einem zweiten Schritt das austauschbare optische Element 8 relativ zu der separaten Haltestruktur 22 grob vorpositioniert und mittels der Klemmeinrichtung 23 fixiert wird und wonach
- in einem dritten Schritt das austauschbare optische Element 8 mittels der Manipulatoreinrichtung 22a relativ zu dem Gehäuse 10 des Lithographieobjektivs 7 mit hoher Genauigkeit ausgerichtet wird.

Die grobe Vorpositionierung erfolgt dabei etwa bis zu einer Ausrichtungsgenauigkeit des optischen Elements 8 von bis zu 1 *µ*m. Die folgende Ausrichtung mit hoher Genauigkeit erreicht Positioniergenauigkeiten von kleiner 10 nm.

In Figur 4 ist eine weitere Ausführungsform eines Lithographieobjektivs 7' mit einem Gehäuse 10' vereinfacht dargestellt. Dabei werden mehrere optische Elemente 13 in Fassungen 14 in dem Lithographieobjektiv 7' gelagert. Des weiteren ist ein austauschbares optisches Element 8'' in einer Fassung 9" auf einer Grundfassung 14' angeordnet. Eine Austauschvorrichtung 12" umfasst dabei eine separate Zuführeinrichtung 28 mit einer ersten Aufnahme 29 für ein zuzuführendes austauschbares optisches Element 8a", welche durch eine erste seitliche Öffnung 17' in dem Gehäuse 10' des Lithographieobjektivs 7' in dasselbe einfahrbar ist und eine separate Entnahmeeinrichtung 30 mit einer zweiten Aufnahme 31 für das zu entnehmende austauschbare optische Element 8b'', welche durch eine zweite seitliche Öffnung 17" in dem Gehäuse 10' des Lithographieobjektivs 7' in dasselbe einfahrbar ist. Dadurch kann ein zu entfernendes austauschbares optisches Element 8" durch die Entnahmeeinrichtung 30 entnommen und synchron ein zuzuführendes austauschbares optisches Element 8a'' durch die Zuführeinrichtung 28 zugeführt werden. Die Zuführeinrichtung 28 weist z.B. einen Speicher 28a zur Ablage der zuzuführenden austauschbaren optischen Elemente 8a" auf. Die Entnahmeeinrichtung 30 weist z.B. einen Speicher 30a zur Ablage der entnommenen austauschbaren optischen Elemente 8b" auf.

Im vorliegenden Ausführungsbeispiel ist das austauschbare optische Element 8" in der Nähe z.B. einer Pupille angeordnet. In Figur 4 sind die genauen Einrichtungen zur Fixierung und Halterung des austauschbaren optischen Elements 8" innerhalb des Lithographieobjektivs 7' nicht näher dargestellt. Diese sind vorzugsweise entsprechend der Figuren 2 und 3 ausgebildet. Das optische Element 8, 8', 8" kann z.B. eine Blende, eine Linse, ein Spiegel, ein Strahlteilerwürfel, ein refraktives oder diffraktives optisches Element oder eine Gruppe aus den genannten Elementen sein.

Ein Verfahren zum Austauschen des austauschbaren optischen Elements 8" innerhalb des Lithographieobjektivs 7' mittels der Austauschvorrichtung 12" kann wie folgt durchgeführt werden:
- in einem ersten Schritt wird die durch die Klemmeinrichtung 23 erfolgte Fixierung des zu entnehmenden austauschbaren optischen Elements 81" auf der die Manipulatoreinrichtung 22a aufweisenden separaten Haltestruktur 22 gelöst, wonach
- in einem zweiten Schritt das zu entnehmende austauschbare optische Element 8" von der Entnahmeeinrichtung 30 erfasst wird, wobei wenigstens annähernd gleichzeitig das zuzuführende austauschbare optische Element 8a" von der Zuführeinrichtung 28 erfasst wird, wonach
- in einem dritten Schritt eine wenigstens annähernd synchrone Bewegung durch die Entnahmeeinrichtung 30 und die Zuführeinrichtung 28 erfolgt, wobei nahezu gleichzeitig das zu entnehmende optische Element 8'' aus dem Lithographieobjektiv 7' entnommen und das zuzuführende optische Element 8a'' in das Lithographieobjektiv 7' eingeführt und auf der separaten Haltestruktur 22 abgelegt wird, wonach
- in einem vierten Schritt das zuzuführende austauschbare optische Element 8a" relativ zu der separaten Haltestruktur 22 grob vorpositioniert und mittels der Klemmeinrichtung 23 fixiert wird, und wonach
- in einem fünften Schritt das zuzuführende austauschbare optische Element 8a" mittels der Manipulatoreinrichtung 22a relativ zu dem Gehäuse 10' des Lithographieobjektivs 7' mit hoher Genauigkeit ausgerichtet wird.

In bestimmten Fällen kann der fünfte Schritt entfallen, wenn eine grobe Vorpositionierung des optischen Elements bezüglich der Abbildungsqualität bereits gute Ergebnisse liefert. In solchen Fällen kann dann auch die Manipulatoreinheit 22a und deren zugeordnete Sensoren 26 sowie die Steuereinrichtung 27 entfallen.

In einem weiteren nicht dargestellten Ausführungsbeispiel kann die Austauschvorrichtung auch als Drehkarussell oder dergleichen ausgeführt sein.

## Patentansprüche

1. Austauschvorrichtung (12,12',12") für wenigstens ein in einer lithographischen Projektionsbelichtungsanlage (1) zumindest mittelbar gelagertes in einer Fassung (9,9',9") angeordnetes austauschbares optisches Element (8,8',8",8a",8b"), mit wenigstens einer Aufnahme (18) für das austauschbare optische Element (8,8',8",8a",8b"), welche durch wenigstens eine Öffnung (17,17',17") in einem Gehäuse (10,10') eines Anlagenteils (7,7',3) der Projektionsbelichtungsanlage (1) in dasselbe einbringbar ist, wobei das austauschbare optische Element (8,8',8",8a",8b") in dem Anlagenteil (7) auf einer separaten Haltestruktur (22) gehalten ist, **dadurch gekennzeichnet, dass** das austauschbare optische Element (8,8',8",8a",8b") zur Fixierung auf der separaten Haltestruktur (22) mittels der Fassung (9,9',9") in eine entsprechend hinreichend steif ausgeführte Klemmeinrichtung (23) eingebracht ist, wodurch die separate Haltestruktur (22) von den Klemmkräften der Klemmeinrichtung (23) wenigstens annähernd entkoppelt ist.

2. Austauschvorrichtung nach Anspruch 1, wobei der Anlagenteil ein Lithographieobjektiv (7,7') und/oder ein Beleuchtungssystem (3) oder Teile davon umfässt.

3. Austauschvorrichtung nach Anspruch 2, wobei die Öffnung (17,17',17") eine seitliche Öffnung bezogen auf die Richtung eines Projektionsstrahls (11) der Projektionsbelichtungsanlage (1) ist.

4. Austauschvorrichtung nach Anspruch 1, wobei die wenigstens eine Aufnahme (18) mittels einer Antriebseinrichtung und einer Führungseinrichtung (19) motorisch einfahrbar ist.

5. Austauschvorrichtung nach Anspruch 1, wobei die Fassung (9) im Bereich der Klemmeinrichtung (23) von Momenten der separaten Haltestruktur (22) und/oder der Klemmeinrichtung (23) entkoppelt ist.

6. Austauschvorrichtung nach Anspruch 1, wobei die separate Haltestruktur (22) relativ zu dem Anlagenteil (7,7',3) eindeutig bestimmt ist.

7. Austauschvorrichtung nach Anspruch 1, wobei die separate Haltestruktur in einer mit dem Gehäuse (10,10') des Anlagenteils (7,7',3) verbundenen Grundfassung (24) gehalten ist.

8. Austauschvorrichtung nach Anspruch 1, wobei das austauschbare optische Element (8,8',8",8a",8b") Referenzflächen zur Erfassung der Position und Orientierung desselben aufweist.

9. Austauschvorrichtung nach Anspruch 1, wobei zur groben Vorpositionierung des austauschbaren optischen Elements auf der separaten Haltestruktur (22) Abstandsscheiben (25) vorgesehen sind.

10. Austauschvorrichtung nach Anspruch 1, wobei die separate Haltestruktur (22) eine Manipulatoreinrichtung (22a) mit wenigstens einem Aktuator zur Einstellung des austauschbaren optischen Elements (8) in wenigstens einem, insbesondere in sechs Freiheitsgraden aufweist.

11. Austauschvorrichtung nach Anspruch 1, wobei ein erstes Sensorsystem (26) zur Ermittlung der relativen Position und Orientierung des austauschbaren optischen Elements (8) zu dem Anlagenteil (7,7',3) auf der separaten Haltestruktur (22) vorgesehen ist.

12. Austauschvorrichtung nach Anspruch 11, wobei eine Feinpositionierung des austauschbaren optischen Elements (8) mit der Manipulatoreinrichtung (22a) durchführbar ist.

13. Austauschvorrichtung nach Anspruch 11 und 12, wobei die Feinpositionierung des austauschbaren optischen Elements (8) mit den Daten des ersten Sensorsystems (26) durch die Manipulatoeinrichtung (22a) von einem ersten Steuerungssystem (27) durchführbar ist.

14. Austauschvorrichtung nach Anspruch 1, wobei wenigstens ein zweites Sensorsystem vorgesehen ist, welches die Position und die Orientierung des austauschbaren optischen Elements (8) während des Austauschvorgangs beim Zuführen und bei der Entnahme ermittelt.

15. Austauschvorrichtung nach Anspruch 14, wobei wenigstens ein zweites Steuerungssystem vorgesehen ist, welches die Führung und den Antrieb der Bewegung der wenigstens einen Aufnahme (18) basierend auf der von dem wenigstens einen zweiten Sensorsystem überwachten Position und Orientierung des austauschbaren optischen Elements (8) beim Zuführen und bei der Entnahme des austauschbaren optischen Elements (8) steuert.

16. Austauschvorrichtung nach Anspruch 1, wobei eine separate Zuführeinrichtung (28) mit einer ersten Aufnahme (29) für ein zuzuführendes austauschbares optisches Element (8",8a",8b"), welche durch wenigstens eine erste seitliche Öffnung (17') in dem Gehäuse (10') des Anlagenteils (7') in dasselbe einfahrbar ist, vorgesehen ist.

17. Austauschvorrichtung nach Anspruch 16, wobei eine separate Entnahmeeinrichtung (30) mit einer zweiten Aufnahme (31) für das zu entnehmende austauschbare optische Element (8",8a",8b"), welche durch wenigstens eine zweite seitliche Öffnung (17") in dem Gehäuse (10') des Anlagenteils (7') in dasselbe einfahrbar ist, vorgesehen ist.

18. Austauschvorrichtung nach Anspruch 17, wobei synchron das zu entfernende austauschbare optische Element (8") durch die Entnahmeeinrichtung (30) entnehmbar und das zuzuführende austauschbare optische Element (8a") durch die Zuführeinrichtung (28) zuführbar ist.

19. Austauschvorrichtung nach Anspruch 16, wobei wenigstens die Zuführeinrichtung (28) oder die Entnahmeeinrichtung (30) einen Speicher (28a,30a) zur Ablage der zuzuführenden oder entnommenen austauschbaren optischen Elemente (8",8a',8b") aufweist.

20. Lithographieobjektiv (7,7') mit mehreren optischen Elementen (8,8',8",8a",8b",13) und mit wenigstens einer Austauschvorrichtung (12,12',12") nach Anspruch 1, wobei wenigstens eines der optischen Elemente (8,8',8",8a",8b") durch die wenigstens eine Austauschvorrichtung (1,2,12',12") austauschbar ist.

21. Beleuchtungssystem (3) für die Mikrolithographie mit einer Austauschvorrichtung (12') nach Anspruch 1 für wenigstens ein in dem Beleuchtungssystem (3) als Anlagenteil der Projektionsbelichtungsanlage (1) zumindest mittelbar gelagertes austauschbares optisches Element (8').

22. Verfahren zur Herstellung von Halbleiterbauelementen unter Verwendung eines Lithögraphieobjektivs (7,7') nach Anspruch 20.

23. Verfahren zur Positionierung eines austauschbaren optischen Elements (8) innerhalb einer lithographischen Projektionsbelichtungsanlage (1) mittels einer Austauschvorrichtung (12) gemäß Anspruch 1, wobei:
- in einem ersten Schritt das austauschbare optische Element (8) auf die separate Haltestruktur (22), welche eine Manipulatoreinrichtung (22a) aufweist, abgelegt wird, wonach
- in einem zweiten Schritt das austauschbare optische Element (8) relativ zu der separaten Haltestruktur (22) grob vorpositioniert und mittels der Klemmeinrichtung (23) fixiert wird, und wonach
- in einem dritten Schritt das austauschbare optische Element (8) mittels der Manipulatoreinrichtung (22a) relativ zu dem Gehäuse oder einem weiteren optischen Element der Projektionsbelichtungsanlage (1) fein positioniert wird.

24. Verfahren zum Austauschen eines austauschbaren optischen Elements (8") innerhalb einer lithographischen Projektionsbelichtungsanlage (1) mittels einer Austauschvorrichtung (12") gemäß Anspruch 17, wobei:
- in einem ersten Schritt die durch die Klemmeinrichtung (23) erfolgte Fixierung des zu entnehmenden austauschbaren optischen Elements (8") auf der eine Manipulatoreinrichtung (22a) aufweisenden separaten Haltestruktur (22) gelöst wird, wonach
- in einem zweiten Schritt das zu entnehmende austauschbare optische Element (8") von der Entnahmeeinrichtung (30) erfasst wird, wobei wenigstens annähernd gleichzeitig das zuzuführende austauschbare optische Element (8a") von der Zuführeinrichtung (28) erfasst wird, wonach
- in einem dritten Schritt eine wenigstens annähernd synchrone Bewegung durch die Entnahmeeinrichtung (30) und die Zuführeinrichtung (28) erfolgt, wobei das zu entnehmende optische Element (8") aus der Projektionsbelichtungsanlage (1) entnommen und das zuzuführende optische Element (8a") in die Projektionsbelichtungsanlage (1) eingeführt und auf der separaten Haltestruktur (22) abgelegt wird, und wonach
- in einem vierten Schritt das zuzuführende austauschbare optische Element (8a") relativ zu der separaten Haltestruktur (22) grob vorpositioniert und mittels der Klemmeinrichtung (23) fixiert wird.

25. Verfahren nach Anspruch 24, wobei in einem fünften Schritt das zuzuführende austauschbare optische Element (8a") mittels der Manipulatoreinrichtung (22a) relativ zu dem Gehäuse der lithographischen Projektionsbelichtungsanlage (1) fein positioniert wird.

## Claims

1. Replacement device (12, 12', 12") for at least one replaceable optical element (8, 8', 8", 8a", 8b") mounted at least indirectly in a lithographic projection exposure apparatus (1) and arranged in a mount (9, 9', 9"), comprising at least one receptacle (18) for the replaceable optical element (8, 8', 8", 8a", 8b"), which can be introduced into a housing (10, 10') of an apparatus part (7, 7', 3) of the projection exposure apparatus (1) through at least one opening (17, 17', 17") in said housing, wherein the replaceable optical element (8, 8', 8",8a", 8b") is held in the apparatus part (7) on a separate holding structure(22), **characterized in that** the replaceable optical element (8, 8', 8", 8a", 8b") is introduced into a correspondingly sufficiently rigidly designed clamping device (23) for fixing on the separate holding structure (22) by means of the mount (9, 9', 9"), whereby the separate holding structure (22) is at least approximately decoupled from the clamping forces of the clamping device (23).

2. Replacement device according to Claim 1, wherein the apparatus part comprises a lithography objective (7, 7') and/or an illumination system (3) or parts thereof.

3. Replacement device according to Claim 2, wherein the opening (17, 17', 17") is a lateral opening relative to the direction of a projection beam (11) of the projection exposure apparatus (1).

4. Replacement device according to Claim 1, wherein the at least one receptacle (18) can be retracted motively by means of a drive device and a guide device (19).

5. Replacement device according to Claim 1, wherein the mount (9) is decoupled from moments of the separate holding structure (22) and/or of the clamping device (23) in the region of the clamping device (23).

6. Replacement device according to Claim 1, wherein the separate holding structure (22) is determined unambiguously relative to the apparatus part (7, 7', 3).

7. Replacement device according to Claim 1, wherein the separate holding structure is held in a basic mount (24) connected to the housing (10, 10') of the apparatus part (7, 7', 3).

8. Replacement device according to Claim 1, wherein the replaceable optical element (8, 8', 8", 8a", 8b") has reference surfaces for detecting the position and orientation thereof.

9. Replacement device according to Claim 1, wherein spacer washers (25) are provided for the coarse prepositioning of the replaceable optical element on the separate holding structure(22).

10. Replacement device according to Claim 1, wherein the separate holding structure (22) has a manipulator device (22a) with at least one actuator for setting the replaceable optical element (8) in at least one, in particular in six, degrees of freedom.

11. Replacement device according to Claim 1, wherein a first sensor system (26) is provided for determining the relative position and orientation of the replaceable optical element (8) with respect to the apparatus part (7, 7', 3) on the separate holding structure (22).

12. Replacement device according to Claim 11, wherein a fine positioning of the replaceable optical element (8) can be carried out by means of the manipulator device (22a).

13. Replacement device according to Claims 11 and 12, wherein the fine positioning of the replaceable optical element (8) can be carried out by a first control system (27) using the data of the first sensor system (26) by means of the manipulator device (22a).

14. Replacement device according to Claim 1, wherein at least one second sensor system is provided which determines the position and the orientation of the replaceable optical element (8) during the replacement operation in the course of supply and in the course of removal.

15. Replacement device according to Claim 14, wherein at least one second control system is provided which controls the guidance and the drive of the movement of the at least one receptacle (18) based on the position and orientation of the replaceable optical element (8) monitored by the at least one second sensor system in the course of supply and in the course of removal of the replaceable optical element (8).

16. Replacement device according to Claim 1, wherein a separate supply device (28) with a first receptacle (29) for a replaceable optical element (8", 8a", 8b") to be supplied, which can be retracted into the housing (10') of the apparatus part (7') through at least one first lateral opening (17') in said housing, is provided.

17. Replacement device according to Claim 16, wherein a separate removal device (30) with a second receptacle (31) for the replaceable optical element (8", 8a", 8b") to be removed, which can be retracted into the housing (10') of the apparatus part (7') through at least one second lateral opening(17"), is provided.

18. Replacement device according to Claim 17, wherein the replaceable optical element (8") to be removed can be removed by the removal device (30) and the replaceable optical element (8a") to be supplied can be supplied by the supply device (28), synchronously.

19. Replacement device according to Claim 16, wherein at least the supply device (28) or the removal device (30) has a store (28a, 30a) for depositing the replaceable optical elements (8", 8a", 8b") to be supplied or the replaceable optical elements (8", 8a", 8b"), that have been removed.

20. Lithography objective (7, 7') comprising a plurality of optical elements (8, 8', 8", 8a", 8b", 13) and comprising at least one replacement device (12, 12', 12") according to Claim 1, wherein at least one of the optical elements (8, 8', 8", 8a", 8b") can be replaced by the at least one replacement device (12, 12', 12").

21. Illumination system (3) for microlithography comprising a replacement device (12') according to Claim 1 for at least one replaceable optical element (8') mounted at least indirectly in the illumination system (3) as apparatus part of the projection exposure apparatus (1).

22. Method for producing semiconductor components using a lithography objective (7, 7') according to Claim 20.

23. Method for positioning a replaceable optical element (8) within a lithographic projection exposure apparatus (1) by means of a replacement device (12) according to Claim 1, wherein:
- in a first step, the replaceable optical element (8) is deposited onto the separate holding structure (22), which has a manipulator device (22a), after which
- in a second step, the replaceable optical element (8) is coarsely prepositioned relative to the separate holding structure (22) and fixed by means of the clamping device (23), after which
- in a third step, the replaceable optical element (8) is finely positioned relative to the housing or a further optical element of the projection exposure apparatus (1) by means of the manipulator device (22a).

24. Method for replacing a replaceable optical element (8") within a lithographic projection exposure apparatus (1) by means of a replacement device (12") according to Claim 17, wherein:
- in a first step, the fixing - effected by the clamping device (23) - of the replaceable optical element (8") to be removed on the separate holding structure (22) having a manipulator device (22a) is released, after which
- in a second step, the replaceable optical element (8") to be removed is picked up by the removal device (30), wherein, at least approximately simultaneously, the replaceable optical element (8a") to be supplied is picked up by the supply device (28), after which
- in a third step, an at least approximately synchronous movement is effected by the removal device (30) and the supply device (28), wherein the optical element (8") to be removed is removed from the projection exposure apparatus (1) and the optical element (8a") to be supplied is introduced into the projection exposure apparatus (1) and deposited on the separate holding structure (22), after which
- in a fourth step, the replaceable optical element (8a") to be supplied is coarsely prepositioned relative to the separate holding structure (22) and fixed by means of the clamping device (23).

25. Method according to Claim 24, wherein, in a fifth step, the replaceable optical element (8a") to be supplied is finely positioned relative to the housing of the lithographic projection exposure apparatus (1) by means of the manipulator device (22a).

## Revendications

1. Dispositif d'échange (12, 12', 12") pour au moins un élément optique (8, 8', 8", 8a", 8b") interchangeable, logé au moins indirectement dans un équipement d'illumination par projection (1) pour la lithographie, placé dans une monture (9, 9', 9"), avec au moins un logement (18) pour l'élément optique (8, 8', 8", 8a", 8b") interchangeable, lequel à travers au moins un orifice (17, 17', 17") dans un boîtier (10, 10') d'une pièce (7, 7', 3) de l'équipement d'illumination par projection (1) est susceptible d'être introduit dans celui-ci, l'élément optique (8, 8', 8", 8a", 8b") interchangeable étant maintenu dans la pièce (7) de l'équipement sur une structure de retenue (22) séparée, **caractérisé en ce que**, pour la fixation sur la structure de retenue (22) séparée, au moyen de la monture (9, 9', 9"), l'élément optique (8, 8', 8", 8a", 8b") interchangeable est introduit dans un système de serrage (23) réalisé en étant suffisamment rigide, suite à quoi, la structure de retenue (22) séparée est au moins approximativement découplée par les forces de serrage du système de serrage (23).

2. Dispositif d'échange selon la revendication 1, la pièce de l'équipement comprenant un objectif (7, 7') de lithographie et/ou un système d'illumination (3) ou des parties de ces derniers.

3. Dispositif d'échange selon la revendication 2, l'orifice (17, 17', 17") étant un orifice latéral par rapport à la direction d'un faisceau de projection (11) de l'équipement d'illumination par projection (1).

4. Dispositif d'échange selon la revendication 1, l'au moins un logement (18) étant susceptible d'être introduit par moteur au moyen d'un système d'entraînement et d'un système de guidage (19).

5. Dispositif d'échange selon la revendication 1, dans la région du système de serrage (23), la monture (9) étant découplée de moments de force de la structure de retenue (22) séparée et/ou du système de serrage (23).

6. Dispositif d'échange selon la revendication 1, la structure de retenue (22) séparée étant clairement définie par rapport à la pièce (7, 7', 3) de l'équipement.

7. Dispositif d'échange selon la revendication 1, la structure de retenue séparée étant maintenue dans une monture de base (24) reliée avec le boîtier (10, 10') de la pièce (7, 7', 3) de l'équipement.

8. Dispositif d'échange selon la revendication 1, l'élément optique (8, 8', 8", 8a", 8b") interchangeable comportant des surfaces de référence pour la détection de la position et de l'orientation de celui-ci.

9. Dispositif d'échange selon la revendication 1, des disques écarteurs (25) étant prévus pour le pré-positionnement grossier de l'élément optique interchangeable sur la structure de retenue (22) séparée.

10. Dispositif d'échange selon la revendication 1, la structure de retenue (22) séparée comportant un système de manipulateurs (22a) avec au moins un actionneur pour le réglage de l'élément optique (8) interchangeable dans au moins un, notamment dans six degrés de liberté.

11. Dispositif d'échange selon la revendication 1, un premier système de capteurs (26) étant prévu pour déterminer la position et l'orientation relatives de l'élément optique (8) interchangeable par rapport à la pièce de l'équipement (7, 7', 3) sur la structure de retenue (22) séparée.

12. Dispositif d'échange selon la revendication 11, un positionnement fin de l'élément optique (8) interchangeable étant réalisable à l'aide du système de manipulateurs (22a).

13. Dispositif d'échange selon la revendication 11 et la revendication 12, le positionnement fin de l'élément optique (8) interchangeable avec les données du premier système de capteurs (26) par le système de manipulateurs (22a) étant réalisable par un premier système de commande (27).

14. Dispositif d'échange selon la revendication 1, au moins un deuxième système de capteurs étant prévu, lequel détermine la position et l'orientation de l'élément optique (8) interchangeable pendant le processus d'échange, lors de l'amenage et du retrait.

15. Dispositif d'échange selon la revendication 14, au moins un deuxième système de commande étant prévu, lequel commande le guidage et l'entraînement du déplacement de l'au moins un logement (18) sur la base de la position et de l'orientation de l'élément optique (8) interchangeable, supervisées par l'au moins un deuxième système de capteurs lors de l'amenage et lors du retrait de l'élément optique (8) interchangeable.

16. Dispositif d'échange selon la revendication 1, un système d'amenage (28) séparé étant prévu avec un premier logement (29) pour un élément optique (8", 8a", 8b") interchangeable qui doit être amené, lequel par au moins un premier orifice (17') latéral dans le boîtier (10') de la pièce (7') de l'équipement peut s'introduire dans celui-ci.

17. Dispositif d'échange selon la revendication 16, un système de retrait (30) séparé étant prévu avec un deuxième logement (31) pour l'élément optique (8", 8a", 8b") interchangeable qui doit être retiré, lequel par au moins un deuxième orifice (17") latéral dans le boîtier (10') de la pièce (7') de l'équipement peut s'introduire dans celui-ci.

18. Dispositif d'échange selon la revendication 17, l'élément optique (8") interchangeable qui doit être retiré pouvant être retiré par le système de retrait (30) et l'élément optique (8a") interchangeable qui doit être amené pouvant être amené par le système d'amenage (28) de manière synchrone.

19. Dispositif d'échange selon la revendication 16, au moins le système d'amenage (28) ou le système de retrait (30) comportant une réserve (28a, 30a) pour déposer les éléments optiques (8", 8a", 8b") interchangeables qui doivent être amenés ou retirés.

20. Objectif pour la lithographie (7, 7') avec plusieurs éléments optiques (8, 8', 8", 8a", 8b",13) et avec au moins un dispositif d'échange (12, 12', 12") selon la revendication 1, au moins l'un des éléments optiques (8, 8' , 8", 8a", 8b") étant interchangeable par l'au moins un dispositif d'échange (12, 12', 12").

21. Système d'illumination (3) pour la micro-lithographie, avec un dispositif d'échange (12') selon la revendication 1, pour au moins un élément optique (8') interchangeable logé au moins indirectement dans le système d'illumination (3) en tant que pièce d'équipement de l'équipement d'illumination par projection (1).

22. Procédé destiné à fabriquer des éléments constitutifs à semi-conducteur en utilisant un objectif pour la lithographie (7, 7') selon la revendication 20.

23. Procédé destiné à positionner un élément optique (8) interchangeable à l'intérieur d'un équipement d'illumination par projection (1) pour la lithographie au moyen d'un dispositif d'échange (12) selon la revendication 1 :
- dans une première étape, l'élément optique (8) interchangeable étant déposé sur la structure de retenue (22) séparée, laquelle comporte un système de manipulateurs (22a), suite à quoi,
- dans une deuxième étape, l'élément optique (8) interchangeable étant grossièrement pré-positionné par rapport à la structure de retenue (22) séparée et étant fixé au moyen du système de serrage (23), et suite à quoi,
- dans une troisième étape, au moyen du système de manipulateurs (22a), l'élément optique (8) interchangeable étant soumis à un positionnement fin par rapport au boîtier ou à un élément optique supplémentaire de l'équipement d'illumination par projection (1).

24. Procédé destiné à remplacer un élément optique (8") interchangeable à l'intérieur d'un équipement d'illumination par projection (1) pour la lithographie, au moyen d'un dispositif d'échange (12") selon la revendication 17,
- dans une première étape, la fixation assurée par le système de serrage (23) de l'élément optique (8") interchangeable qui doit être retiré sur la structure de retenue (22) séparée comportant un système de manipulateurs (22a) étant désolidarisée, suite à quoi
- dans une deuxième étape, l'élément optique (8") interchangeable qui doit être retiré étant saisi par le système de retrait (30), au moins à peu près simultanément, l'élément optique (8a") interchangeable qui doit être amené étant saisi par le système d'amenage (28), suite à quoi
- dans une troisième étape, il s'effectue un déplacement au moins approximativement synchrone du système de retrait (30) et du système d'amenage (28), l'élément optique (8") qui doit être retiré étant retiré de l'équipement d'illumination par projection (1) et l'élément optique (8a") qui doit être amené étant introduit dans l'équipement d'illumination par projection (1) et déposé sur la structure de retenue (22) séparée, et suite à quoi
- dans une quatrième étape, l'élément optique (8a") interchangeable qui doit être amené étant grossièrement pré-positionné par rapport à la structure de retenue (22) séparée et fixé au moyen du système de serrage (23).

25. Procédé selon la revendication 24, dans une cinquième étape, au moyen du système de manipulateurs (22a), l'élément optique (8a") interchangeable qui doit être amené étant soumis à un positionnement fin par rapport au boîtier de l'équipement d'illumination par projection (1) pour la lithographie.
